Europäisches Patentamt

European Patent Office

Office européen des brevets

(11) Publication number:

**0 109 193**
**B1**

(12) **EUROPEAN PATENT SPECIFICATION**

(45) Date of publication of patent specification: **24.05.89**

(21) Application number: **83306244.1**

(22) Date of filing: **14.10.83**

(51) Int. Cl.⁴: **G 03 F 7/20**

(54) **X-ray lithographic system.**

(30) Priority: **15.10.82 JP 179851/82**

(43) Date of publication of application:
**23.05.84 Bulletin 84/21**

(45) Publication of the grant of the patent:
**24.05.89 Bulletin 89/21**

(84) Designated Contracting States:
**DE FR GB NL**

(56) References cited:
**EP-A-0 083 394**
**US-A-4 242 588**
**SOLID STATE DEVICES, ESSDERC-SSSDT**
**MEETING AT MUNICH, 13th-16th September**
**1982, pages 121-141, Physik Verlag, Weinheim,**
**DE; A. HEUBERGER et al.: "X-ray lithography**
**with synchrotron radiation"**
**NUCLEAR INSTRUMENTS & METHODS IN**
**PHYSICS RESEARCH, vol. 195, April 1982,**
**pages 162-173, North-Holland Publishing Co.,**
**Amsterdam, NL; R. TATCHYN et al.: "New**
**monochromator designs for the soft X-ray**
**range"**

(73) Proprietor: **HITACHI, LTD.**
**6, Kanda Surugadai 4-chome Chiyoda-ku**
**Tokyo (JP)**

(72) Inventor: **Kimura, Takashi**
**2-11-18, Megurida-cho Higashimurayama-shi**
**Tokyo (JP)**
Inventor: **Obayashi, Hidehito**
**6-8-24, Shimo-Shakujii**
**Nerima-ku Tokyo (JP)**
Inventor: **Mochiji, Kozo**
**17-3-301, Oiwake-cho**
**Hachioji-shi Tokyo (JP)**

(74) Representative: **Calderbank, Thomas Roger**
**et al**
**MEWBURN ELLIS & CO. 2/3 Cursitor Street**
**London EC4A 1BQ (GB)**

(56) References cited:
**NUCLEAR INSTRUMENTS & METHODS, vol.**
**172, no. 1/2, May 1980, pages 387-391, North-**
**Holland Publishing Co., Amsterdam, NL; W.K.**
**WARBURTON et al.: "Soft X-ray**
**microscopy/lithography branch line at SSRL"**

# Description

The present invention relates to an X-ray lithographic system.

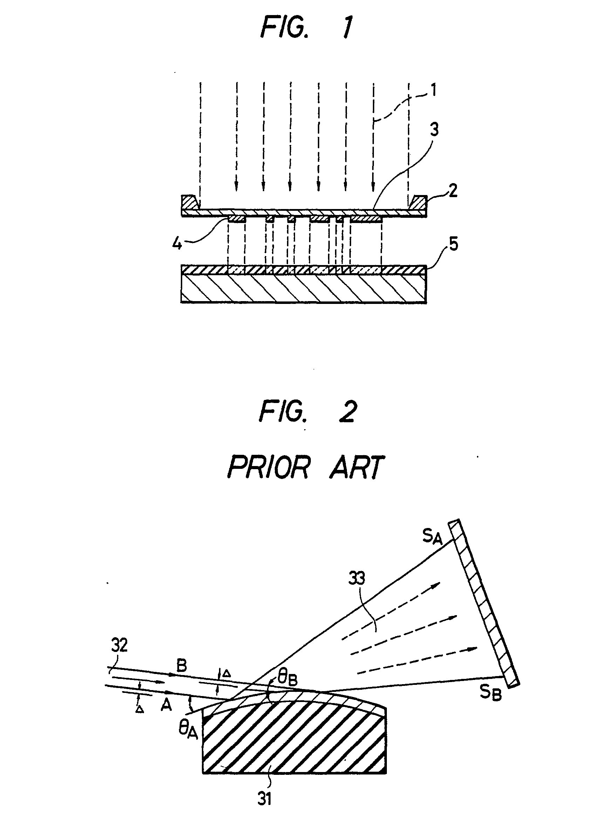

X-ray lithography is a method wherein, as shown in Figure 1 of the accompanying drawings, a mask 2 is irradiated with X-rays 1, and a mask pattern made up of an X-ray transmissive material 3 and an X-ray absorptive material 4 is transferred to a radiation sensitive object e.g. a resist film 5 located behind the mask. Usually the X-rays are obtained from the point X-ray source of an electron beam excitation type rotating anode X-ray tube. However, use of such a source creates problems in that the intensity of the X-rays is low and that the resolution degrades due to penumbra blurring ascribable to a divergent X-ray flux. In contrast, synchrotron radiation is about $10^3$ times higher in intensity than a point X-ray source and exhibits good collimation. Therefore, in order to transfer a pattern having dimensions in the order of submicrons, it is highly desirable to use a synchrotron as the X-ray source.

Although the cross-section of a synchrotron radiation flux differs somewhat depending upon the size of the synchrotron, it is generally in the shape of an ellipse having a minor axis of approximately 20 to 30 mm and a major axis of approximately 40 to 60 mm at a position which is about 10 m distant from the synchrotron orbit. However, the radiation has an intensity distribution in the direction perpendicular to the plane of the synchrotron orbit. Hence the area over which a resist film can be exposed uniformly to X-rays is limited to a band-like area having a width of several millimetres. Hence it is difficult to expose uniformly a silicon wafer of large diameter.

In order to solve this problem, consideration has been given to moving the mounting stages for the mask and the wafer relative to the synchrotron radiation, to scan the surfaces of the mask and wafer with the radiation. If this is done, however, new problems arise in that mechanisms for positioning the mask and wafer and mechanisms for moving the mask and wafer mounting stages are each required, resulting in the system having a complicated structure. There is the further problem that the mask and wafer may be vibrated by the operation of the moving mechanisms during the exposure, making precise pattern transfer impossible.

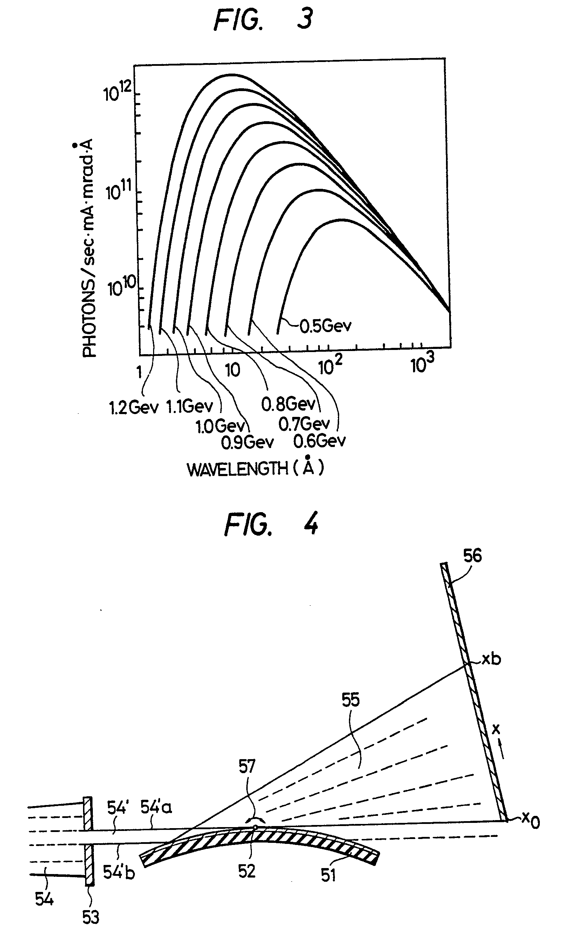

In order to avoid this problem, there has been proposed a method wherein, as shown in Figure 2, a synchrotron radiation 32 is reflected by a convex reflector on the form of a mirror 31 so as to enlarge the cross-sectional area of a radiating flux 33 (IBM Research Report, RC8220, 1980). However, synchrotron radiation has a continuous spectrum as shown in Figure 3. Hence, a wavelength component which has a critical glancing angle smaller than the angle of incidence $\theta_A$ of a flux component A to the mirror 31 in Figure 2 is projected onto a specimen surface $S_A$ only to a very small degree because the reflection factor for such a component becomes very small. On the other hand, the angle of incidence $\theta_B$ of a flux component B to the mirror 31 is $\theta_B < .127_A$, and radiation flux of shorter wavelength is projected to a greater degree on a specimen surface $S_B$ than on the specimen surface $S_A$. As a result of this, there is a distribution on the wavelength of the radiation projected on the specimen, and the specimen cannot be uniformly exposed to radiation.

Even where the wavelength distribution of the radiation projected on the specimen is reduced by the use of monochromatized radiation, the use of a convex mirror means that reflected radiation of equal flux widths $\Delta$ in the flux components A and B are magnified by unequal factors, and the reflection factor has incidence angle-dependency even within the critical glancing angle. Thus an intensity distribution still occurs in the radiation projected onto the specimen, and uniform exposure over the whole specimen surface cannot be performed.

The present invention seeks to overcome these problems and thus improve the uniformity of an X-ray flux to which the object to be irradiated is exposed. It does this by moving the reflector relative to the flux to vary the angles of incidence of the flux on the reflector. The varying of the angles of incidence causes the various components of the flux (considering components of the flux both in position and wavelength) to be reflected to different parts of the object as the reflector moves, hence enabling a more uniform distribution of radiation density to be achieved.

As the uniformity of the radiation distribution increases, so does the area which can be exposed sufficiently uniformly to give good resolution of the projection of a mask, and thus the present invention is particularly useful for exposing a semiconductor wafer to relatively large size.

The reflector is preferably rotated or rotatively oscillated about an axis eccentric to the centre of curvature of the reflector. It is also possible to move the reflector linearly, e.g. oscillation vertically or obliquely, but this is more difficult to achieve in practice.

A reflector with a reflection surface forming part of the curved surface of a cylinder may be used, in which case the axis of rotation or rotary oscillator is preferably parallel to the longitudinal axis of the cylinder. Alternatively a reflector with a reflecting surface forming part of a sphere may be used. In either case, the axis of rotation or rotary oscillation is preferably perpendicular to the directions of incidence of the radiation flux.

It is preferable that a projection of the cross-section of beam intersects the axis of rotation or rotary oscillation of the reflector. One edge of the flux may be incident on the reflector at a point of the reflector at or adjacent the axis.

Embodiments of the present invention will now be described, by way of example, with reference to the accompanying drawings, in which:

Figure 1 is a schematic view showing the principles of X-ray lithography;

Figure 2 is a schematic view showing a known method of enlarging radiant flux with a convex mirror;

Figure 3 is a graph showing the wavelength characteristics of electron synchrotron radiation;

Figure 4 is a schematic view for explaining the principle of the present invention;

Figure 5 is a graph showing the intensity distributions of radiant fluxes provided by a prior-art system; and

Figures 6 and 7 are graphs each showing the effect of the present invention.

Embodiment 1:

An example of the present invention will now be described with reference to Figure 4. A convex reflector in the form of an arcuate convex mirror 51, is formed by a gold (Au) layer 30 to 50 nm thick formed on an arcuate quartz plate having a radius of curvature R of 2m.

Synchrotron radiation 54 was incident on a screen having a split 53 of width W of 5 mm so that the split passed a part 54' of the radiation which permitted effective exposure. The radiation was incident on the mirror 51 with the latter stationary.

The electron acceleration energy E of the synchrotron generating the synchrotron radiation was 1.0 GeV ($10^9$ eV), the electron polarization flux intensity M was 1 T, and the acceleration current I was 100 mA.

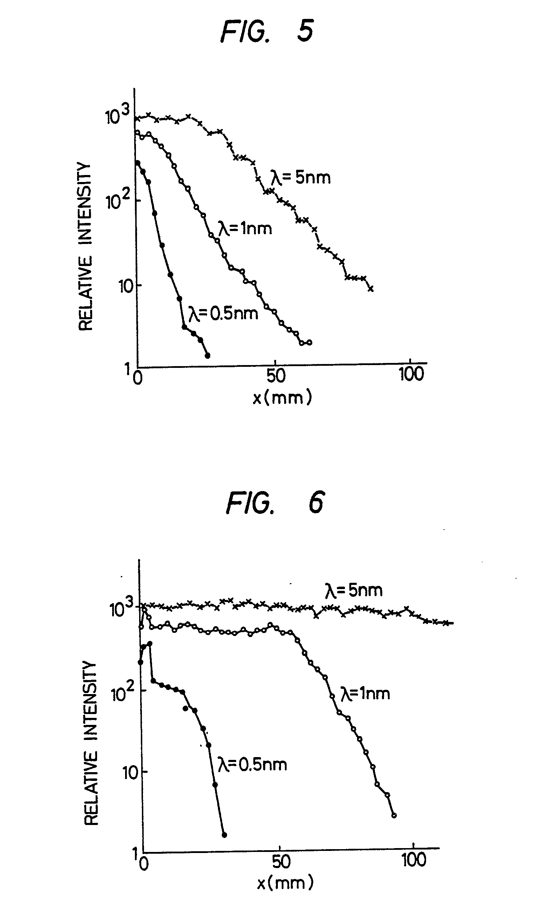

The position of the mirror 51 was set so that the angles of incidence of the radiation 54' to the mirror 51, were such that an upper component 54'a of the radiation 54' was tangential to the mirror 51. The angle of incidence of the lower component 54'b of the radiation 54' to the mirror 51 was then approximately 70 mrad, corresponding to the critical glancing angle $\theta_c$ of radiation at a wavelength $\lambda = 1$ nm, so that the reflection factor of radiation of shorter wavelength lowered abruptly. The intensity distribution of the resulting reflected light 55 on a wafer 56 is shown in Figure 5. The distance from the mirror 51 to the wafer 56 was 1 m.

As seen from Figure 5, when the convex mirror 51 was stationary, the relative intensities of the reflected radiation 55 at respective wavelengths is significantly reduced as the distance $x$ from the lower end $x_o$ of the wafer 56 increases. Thus it is impossible to irradiate the whole surface of the wafer 56 uniformly with the mirror 51 stationary.

Figure 6 shows a similar intensity distribution obtained under similar conditions, except that the mirror 51 was oscillated at an amplitude of $\pm 100$ mrad as indicated by arrows 57 about an axis 52 which lay on the line of radiant flux 54'a. From Figure 6, it can be seen that when the convex mirror 51 is oscillated as described above, the width of wafer 56 which can be uniformly irradiated with the reflected radiation 55 is significantly increased and that a range up to about 50 mm can be uniformly irradiated with radiation components having wavelengths $\lambda$ of at least 1 nm.

Since the width W of the incident radiation 54' is 5 mm as stated above, the width of the radiation reaching the wafer 56 has been enlarged approximately 10 times by the present invention.

Moreover, as illustrated in Figure 6, reflected radiation having a wavelength of 5 nm can irradiate a wafer width of at least 10 cm very uniformly. It is accordingly understood that the present invention is effective for enlarging the area which can be uniformly irradiated.

Where the rotational axis of the mirror 51 deviates from the line of the incident flux 54'a there is a decrease in area in which uniform exposure intensity is achieved. It is therefore preferable to cause both to intersect orthogonally as closely as possible.

Embodiment 2:

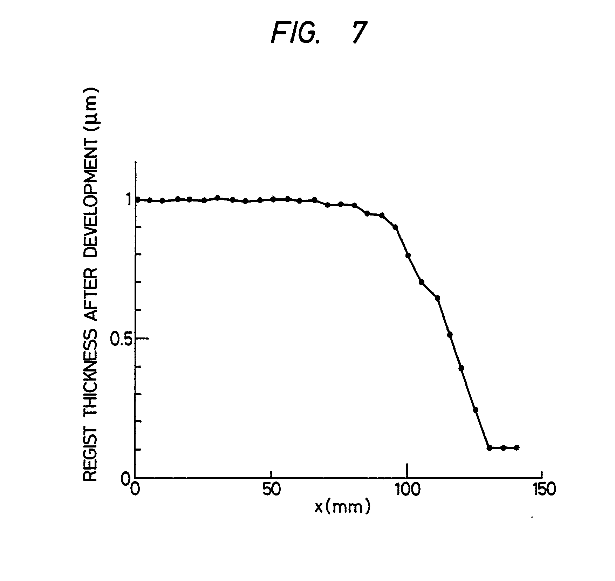

Figure 7 shows the result obtained when a polymethyl methacrylate (PMMA) resist film having a thickness of 1 μm was irradiated with radiation whose area was enlarged by the reflecting convex mirror system for synchrotron radiation used in Embodiment 1, and the distribution of the thickness of the resist film remaining after development, relative to distance x along the wafer was investigated. It is evident that the range in which a uniform film thickness was attained is about 80 mm wide and is much larger than with the radiation of $\lambda = 1$ nm illustrated in Figure 6. The reason for this is thought to be that, since the PMMA resist is sensitive over a considerably wide wavelength region, very high uniformity will have been achieved over a wide range due to the influence of longer wavelength components contained in the reflected radiation.

In the above embodiments a convex reflector having an arcuate cross-section was rotatively oscillated about the axis 54, it may of course be rotated in one direction only about the axis 54.

Also, when a cylindrical convex mirror is employed and is similarly rotated or rotatively oscillated, the area of uniform irradiation intensity can be enlarged, and this is very useful for carrying out X-ray lithography.

As described above, the present invention consists in that a convex reflector is moved relative to the incident flux, preferably by rotation or rotary oscillation thereby to enhance the uniformity of an irradiation intensity.

The rotation or rotary oscillation is preferably achieved, for the case of an arcuate or cylindrically curved convex mirror, by having the axis of rotation parallel to the centre axis of the mirror, the axis being eccentric to that axis. Thus, reflected light from the convex mirror is projected on a mask or a resist film as if the former scanned the latter, with the result that a very uniform distribution of radiation intensity is achieved over a wide range. Even when the convex mirror is vibrated vertically or in an oblique direction, the uniformity of the radiation intensity distributed is enhanced, and improved performance is possible. However, it is usually easier to rotate or rotatively oscillate the convex mirror around a chosen rotational axis.

Using a system according to the present invention, the area which can be uniformly exposed to radiation may be significantly increased, and this is very usual for processing a wafer of large area. The reflection factor of radiation from the convex reflector used in the present invention is, for example, approximately 10% at very short wavelengths of 1 to 5 nm in a wavelength region effective for X-ray lithography. Since, however, the intensity of synchrotron radiation is approximately 3 orders higher than the intensity of a conventional X-ray source such as a Coolidge tube system, the required exposure time becomes negligible compared with the time necessary for aligning the mask and the wafer. As a result, the throughput has been remarkably enhanced. In addition when compared with the system previously described wherein the exposure area is enlarged by moving the mask and the wafer, use of the system according to the present invention may significantly reduce vibrations of the mask and the wafer. This enhances the precision of transfer and alignment of a mask pattern with dimensions in the order of submicrons. Vibrations caused by the rotation or rotary oscillation of the convex mirror may be made less than those in the prior-art system. In addition, the mechanism for moving the reflector and a mechanism for aligning mask and wafer can be connected by interposing vacuum bellows or the like, so that the vibrations can be further reduced.

Furthermore, since the angle of incidence of the radiation can be set at desired values by suitably selecting the radius of curvature or the amplitude of the rotary oscillation of the convex reflector, a radiation component of short wavelengths which induces degradation of the characteristics of the wafer may be eliminated.

In the present invention the action of the reflector is independent of the shape of its rear surface. It is therefore possible to use, but also convex mirrors having various cross-sectional shapes, for example, the convex mirror shown in Figure 2, rather than the circular or arcuate mirror shown in Figure 4.

## Claims

1. An X-ray lithographic system having a convex reflector (51) in the path of radiation flux (54) from means (53) determining the cross-sectional area of the radiation flux (54') to a radiation sensitive object (56); characterised in that: the convex reflector (51) is movable relative to the radiation flux (54) to vary the angles of incidence of the flux (54') on the reflector (51).

2. An X-ray lithographic system according to claim 1 wherein the convex reflector (51) is movable relative to the flux 54 by rotation or rotary oscillation about an axis (52) which is eccentric relative to the centre of curvature of the convex reflector (51).

3. An X-ray lithographic system according to claim 2, wherein the convex reflector (51) has a reflecting surface in the form of part of a cylinder, the axis (52) being parallel to the longitudinal axis of the cylinder.

4. An X-ray lithographic system according to claim 2, wherein the convex reflector (51) has a reflecting surface in the form of a part of a sphere.

5. An X-ray lithographic system according to any one of claims 2 to 4, wherein the axis (52) is substantially perpendicular to the direction of incidence of the radiation flux (54).

6. An X-ray lithographic system according to any one of claims 2 to 5 wherein the axis (52) lies within the projected cross-section of the radiation flux (54').

7. An X-ray lithographic system according to any one of claims 2 to 6 wherein the axis (52) is at or adjacent a point on the surface of the reflector (51) at which an edge (54'a) of the flux (54') is incident.

8. An X-ray lithographic system according to any one of the preceding claims having a mask with a predetermined pattern between the reflector (51) and the object (56).

## Patentansprüche

1. Röntgenstrahl-Lithografiesystem mit einem konvexen Reflektor (51) im Weg des Strahlungsflusses (54) von einer Einrichtung (53), die die Querschnittsfläche des Strahlungsflusses (54') bestimmt, zu einem strahlungsempfindlichen Objekt (56); dadurch gekennzeichnet, daß der konvexe Reflektor (51) relativ zum Strahlungsfluß (54) beweglich ist, um die Einfallswinkel des Flusses (54') auf den Reflektor (51) zu verändern.

2. Röntgenstrahl-Lithografiesystem nach Anspruch 1, wobei der konvexe Reflektor (51) durch Drehung oder Drehschwingung um eine Achse (52), die relativ zum Mittelpunkt der Krümmung des konvexen Reflektors (51) exzentrisch ist, relativ zu dem Fluß (54) beweglich ist.

3. Röntgenstrahl-Lithografiesystem nach Anspruch 2, wobei der konvexe Reflektor (51) eine reflektierende Oberfläche in Form eines Zylinderteils hat, wobei die Achse (52) parallel zu der Längsachse des Zylinders ist.

4. Röntgenstrahl-Lithografiesystem nach Anspruch 2, wobei der konvexe reflektor (51) eine reflektierend Oberfläche in Form eines Kugelteils hat.

5. Röntgenstrahl-Lithografiesystem nach einem der Ansprüche 2 bis 4, wobei die Achse (52) im wesentlichen senkrecht zu der Einfallsrichtung des Strahlungsflusses (54) ist.

6. Röntgenstrahl-Lithografiesystem nach einem der Ansprüche 2 bis 5, wobei die Achse (52) innerhalb des projizierten Querschnitts des Strahlungsflusses (54') liegt.

7. Röntgenstrahl-Lithografiesystem nach einem der Ansprüche 2 bis 6, wobei die Achse (52) an oder unmittelbar neben einem Punkt auf der Oberfläche des Reflektors (51) ist, an dem ein Rand (54'a) des Flusses (54') einfällt.

8. Röntgenstrahl-Lithografiesystem nach einem der vorhergehenden Ansprüche, das eine Maske mit einer vorgegebenen Struktur zwischen dem Reflektor (51) und dem Objekt (56) hat.

## Revendications

1. Système de lithographie aux rayons X, possédant un réflecteur convexe (51) situé sur le trajet d'un flux de rayonnement (54) s'étendant depuis des moyens (53) de détermination de la surface en coupe transversale du flux de rayonnement (54') jusqu'à un objet (56) sensible au rayonnement; caractérisé en ce qu'on peut déplacer le réflecteur convexe (51) par rapport au flux de rayonnement (54) pour modifier les angles d'incidence du flux (54') sur le réflecteur (51).

2. Système de lithographie aux rayons X selon la revendication 1, dans lequel le reflécteur convexe (51) est déplaçable par rapport au flux (54) par une rotation on une oscillation de rotation autour d'un axe (52), qui est excentré par rapport au centre de courbure du réflecteur convexe (51).

3. Système de lithographie aux rayons X selon la revendication 2, dans lequel le réflecteur convexe (51) possède une surface réfléchissante réalisée sous la forme d'une partie d'un cylindre, l'axe (52) étant parallèle à l'axe longitudinal du cylindre.

4. Système de lithographie aux rayons X selon la revendication 2, dans lequel le réflecteur convexe (51) possède une surface réfléchissante ayant la forme d'une partie de sphère.

5. Système de lithographie aux rayons X selon l'une quelconque des revendications 2 à 4, dans lequel l'axe (52) est sensiblement perpendiculaire à la direction d'incidence du flux de rayonnement (54).

6. Système de lithographie aux rayons X selon l'une quelconque des revendications 2 à 5, dans lequel l'axe (52) est situé dans la section transversale projetée du flux de rayonnement (54').

7. Système de lithographie aux rayons X selon l'une quelconque des revendications 2 à 6, dans lequel l'axe (52) est situé en ou au voisinage d'un point sur la surface du réflecteur (51), sur lequel tombe un bord (54'a) du flux (54').

8. Système de lithographie aux rayons X selon l'une quelconque des revendications précédentes, comportant un masque muni d'une configuration prédéterminée et situé entre le réflecteur (51) et l'objet (56).

## FIG. 1

## FIG. 2

## PRIOR ART

## FIG. 3

## FIG. 4

## FIG. 5

## FIG. 6

## FIG.  7